# EUROPEAN PATENT SPECIFICATION

(11) **EP 0 282 360 B1**
(45) Date of publication and mention of the grant of the patent: **02.11.1995**
(21) Application number: 88302227.9
(22) Date of filing: 14.03.1988
(51) Int. Cl.: H01L 39/24, H01L 39/12, H01F 6/06

(54) **Method for manufacturing components of superconducting ceramic oxide materials**
Verfahren zur Herstellung von Komponenten aus supraleitenden oxidkeramischen Materialien
Méthode de fabrication de composants en matériaux oxide céramique supraconducteurs

(30) Priority: 12.03.1987 JP 58466/87; 11.11.1987 JP 284627/87; 11.11.1987 JP 284628/87
(43) Date of publication of application: 14.09.1988
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo, 157 (JP)
(74) Representative: Milhench, Howard Leslie

(56) References cited:
- EP-A- 0 202 895
- EP-A- 0 285 106
- EP-A- 0 286 106
- WO-A-88/10011
- DE-A- 3 815 185
- J. APPL. PHYS., vol. 52, no. 8, August 1981, pages 5107-5111, American Institute of Physics; Y. MATSUI et al.: "Laser anneqling to produce ferroelectric-phase PbTiO3 thin films"
- JAPANESE JOURNAL OF APPLIED PHYSICS, vol. 27, no. 2, February 1988, pages L231-L233, Part 2, Tokyo, JP; N. AIZAKI et al.: "YBa2Cu3Oy super-conducting thin film obtained by laser annealing"

## Description

### BACKGROUND OF THE INVENTION

This invention relates to superconducting ceramic components and methods for manufacturing the same.

It has been known to use metallic materials such as Nb3Ge to wind a coil to form a superconducting magnet since such metallic materials have a high ductility and malleability. However such metallic materials do not have a high Tc, and in recent years, superconducting ceramics which have a high Tc have attracted the interest of researchers. However, such superconducting ceramics are fragile and have low ductility and malleability, and therefore it has been quite impossible to form a superconducting coil from a conductor made of such superconducting ceramics.

### OBJECTS AND SUMMARY OF THE INVENTION

It is therefore the object of the present invention to provide a high Tc superconductor component in any desired form and to provide a method of manufacturing a high Tc superconductor component in any desired form, which method is suitable for mass-production.

EP 0202895A discloses that a laser may be used to melt A-15, Chevrel or B1 materials, including NbN, to form an elongate superconducting tape which is subsequently used like a conventional tape or wire.

J. Appl. Phys. 52(8), August 1981, AIP, US, pp. 5107-5111, Y. Matsui et al. "Laser Annealing to produce ferroelectric-phase PbTᵢO₃ thin films" discloses formation of ferroelectric components by laser annealing a ceramic film.

Phys. Rev. Lett., Vol. 58, No. 4, 26 January 1987, pp. 408-410, R.J. Cava et al. "Bulk Superconductivity at 36K in La_{1.8} Sr_{0.2} CuO₄" discloses formation of a superconducting phase by heating a ceramic layer in an oxidising atmosphere.

EP-A-0088666 discloses fabrication of a microcircuit comprising alternating conducting and insulating regions in a substrate of an organic quasi-unidimensional conductor, by electron beam irradiation.

The present invention is defined in claim 1.

The invention takes advantage of the fact that the superconductivity of a material is not only dependent upon its chemical composition but also is dependent upon the orderliness of its structure, and proposes to render a disordered non-superconducting structure into an ordered superconducting structure by irradiation.

By selectively irradiating only specific regions of a structure high Tc superconductors can be formed into coils and other shapes which have hitherto been unobtainable.

In accordance with an embodiment of the present invention which is described hereinafter, an oxide mixture prescribed for constituting a superconducting ceramic is first deposited in the form of a thin film onto a substrate by sputtering. By making use of sputtering to form the thin film, an amorphous or other structure of the resultant film is obtained which is abundant in lattice defects and/or imperfections so that the resistivity of the ceramic material is rather high. Prescribed portions of the thin film are then irradiated with a laser beam which, for example, scans the surface of the ceramic layer within a constant width, strip-shaped region of the layer. The irradiated portion of the layer is melted and annealed by the laser and recrystallizes as it cools. By virtue of the annealing effect of the laser, the number of lattice defects and imperfections is decreased and the amount of lattice strain is decreased, so that a microcrystalline structure having superconductive properties is obtained only in the irradiated regions whereby a superconducting pattern may be obtained. The recrystallization results furthermore in impurities contained in the ceramic material being redistributed and collected near the surface of the thin film layer so that a high purity superconducting ceramic can be obtained in the thickness of the thin film.

The sputtered ceramic material may for example be such as those represented by the formulae (Y₁₋ₓBaₓ)₂Cu0₄, hereinafter called YBCO, where x = 0.01 to 0.1 and preferably 0.05 to 0.1, (La₁₋ₓBaₓ)₂Cu0₄, hereinafter called BLCO where x = 0.01 to 0.1 and preferably 0.05 to 0.1, (La₁₋ₓSrₓ)₂Cu0₄, hereinafter called SLCO, where x = 0.01 to 0.1 and preferably 0.05 to 0.1, and (La₁₋ₓAₓ)₂Cu0₄, where A represents an element in Group IIa of the Japanese Periodic Table and where x = 0.01 to 0.1 and preferably 0.05 to 0.1. The irradiation of the ceramic layer is carried out in an oxidizing atmosphere, and so the proportions of the above composition may be decreased correspondingly so that the desired stoichiometry are obtained taking account of oxidation of the irradiated thin film portions.

Those parts of the thin film layer intervening between neighbouring superconducting portions function as insulators which isolate the superconducting portion from its surroundings and also provide the resulting superconducting device with an even upper surface which enables multi-layered structures to be formed.

This isolating effect is advantageous in view of the fact that in the prior art the characteristics of superconducting ceramics have tended to be influenced by the material which is in contact with the ceramics in the structure of the superconducting device. For instance, when a substrate made of silicon oxide or silicon nitride has been used, acid-base reactions have been known to occur between the substrate and an oxide superconducting ceramic layer formed thereon.

As will be appreciated from consideration of the following descriptions, the present invention enables superconductors to be formed in various shapes by a method which is very simple as compared to photolithography so that the present invention can be particularly effective when applied to mass-production manufacturing.

Further features of the invention are set forth with particularity in the appended claims and will become apparent to those possesssed with the relevant skills from consideration of the following description, given with reference to the accompanying drawings, of exemplary embodiments of the invention.

### BRIEF DESCRIPTION OF THE DRAWINGS

Figs. 1(A) to 1(C) are side views illustrating a first exemplary manufacturing process in accordance with the present invention;
Figs. 2(A) to 2(C) are side views illustrating a second exemplary manufacturing process in accordance with the present invention;
Fig. 3 is a perspective view illustrating a third exemplary manufacturing process in accordance with the present invention;
Fig. 4 is a cross sectional view illustrating a fourth exemplary manufacturing process in accordance with the present invention;
Fig. 5 is a perspective view illustrating a fifth exemplary manufacturing process in accordance with the present invention;
Fig. 6 is a perspective view illustrating a sixth exemplary manufacturing process in accordance with the present invention; and
Figs. 7 and 8 are graphical diagrams showing the relationship between the resistivity and the temperature of superconducting oxide ceramics manufactured in accordance with the present invention.

### DETAILED DESCRIPTION OF THE EMBODIMENTS

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

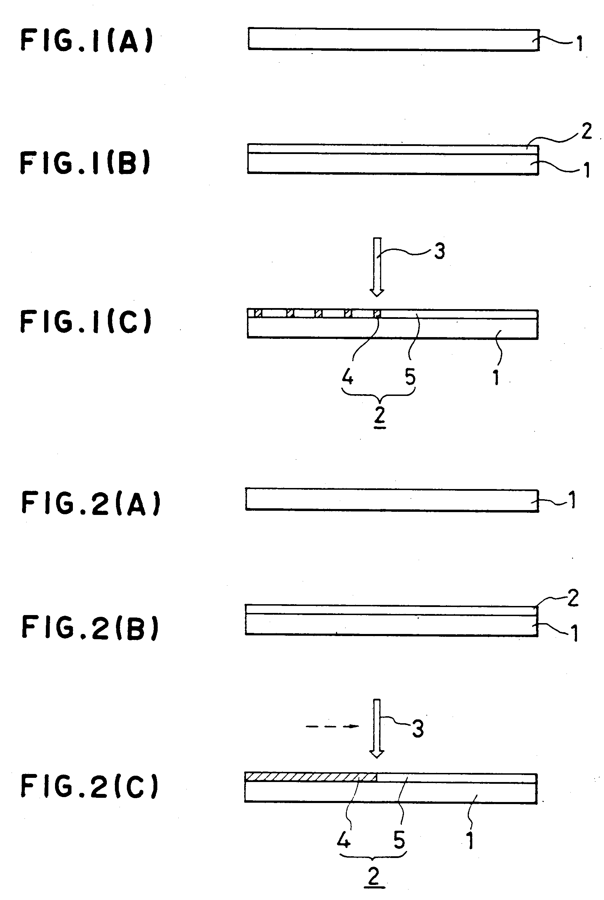

Referring to Figs. 1(A) to (C), a manufacturing process in accordance with the present invention will be described. In Fig. 1(A), a substrate 1 may be made of a ceramic material such as alumina, silicon oxide, aluminium nitride, zirconia, yttria or YSZ(yttria stabilized zircon), or may be made of metal or of glass. YSZ, yttria or zirconia are particularly suitable having regard to the desirability of matching the coefficient of thermal expansion of the substrate to that of the superconducting layer formed thereon as hereinafter described. The differential coefficient of thermal expansion between the underlying substrate and the overlying ceramic thin film should be as small as possible and preferably within 50% of the thermal expansion coefficient of the ceramic thin film, since if the substrate and the ceramic thin film have substantially different thermal expansion coefficients, then strain developed between them may hinder the formation of a superconducting structure by recrystallization of the ceramic film.

A ceramic film of BLCO of 0.5 to 20 microns thickness, e.g. 2 microns, is formed on the substrate 1 by sputtering as is illustrated in Fig.1(B). The sputtering is carried out with a target mixture conforming to the formula (La₁₋ₓBaₓ)₂CuO₄, where x=0.075 for example. During the sputtering, the substrate 1 is placed in an atmosphere of argon to which a small amount of oxygen is added, and the sputtering is effected at a temperature of from room temperature to 400°C, e.g. 250°C.

Having formed the ceramic film 2 by sputtering, the next step as shown in Fig. 1(C) is to irradiate the ceramic thin film using a series of laser beam pulses 3 of 1.06 microns wavelength derived by means of a YAG laser. Each laser pulse is radiated to a circular spot described on the film which shares a 60-80% area with the irradiating spot for the preceding pulse (and also of the subsequent pulse). The laser beam is scanned across the ceramic film at a scanning speed of 2m/min. The pulse frequency is from 5 to 30 KHz, e.g. 8 KHz. The spot diameter is 50 microns. By virtue of this irradiation, the irradiated portions of the ceramic film are melted and then recrystallized. The whole substrate is heated during the laser processing to around 300-800°C, e.g. 600°C, by means of a halogen lamp. By providing this high temperature environment, it is ensured that the film does not crack as as result of too rapid cooling to room temperature from the temperature of 1300°C or higher which is momentarily experienced at the irradiated portion.

As a result of the process illustrated in Figs. 1(A) to 1(C) and described above, a superconductor is fabricated in the form of a plurality of strips 4 positioned on the film 2 with intervals therebetween. The Tc of the strips 4 was measured to be 29°K.

In a modification of the foregoing embodiment, an excimer laser (Kr, KrC1 for example) may be used instead of the YAG laser, and a strip portion of the ceramic layer of from 5-100 microns wide can be irradiated in a single operation using a linear laser beam derived by squeezing with an optical system a pulsed laser beam having a 20 x 30 mm² cross-sectional area. Also, the first embodiment can be carried out making use of a pulsed laser beam emitted from an excimer laser (wavelength =0.25 micron). In this case, the pulse frequency is chosen at about 100KHz which causes the prescribed irradiated portions of the ceramic film to be heated momentarily to about 1000°C or higher. Other manufacturing conditions for carrying out the process using an excimer laser are the same as for the process with a YAG laser. Since the power of an excimer laser is relatively high, the ceramic layer can be oxidized in an oxidizing atmosphere by the irradiation so that, for depositing the ceramic film, a sputtering target comprising (La₁₋ₓBaₓ)₂CuO_{4-d} may be used, where d is a compensatory factor for cancelling out the oxygen increment due to laser annealing of the ceramic in an oxidizing atmosphere, and x=0.075 for example. According to experiments, conducted with the process of Figs. 1(A) to 1(C) thus a Tc of 43°K was obtained for the resultant superconductor.

Fig. 2 shows a second embodiment of the invention. In this embodiment, substantially the same procedure is repeated as for the preceding embodiment except as described below. A substrate 1 is irradiated with pulses having an elongated rectangular cross-section which are emitted from an excimer laser of 0.25 micron wavelength. The irradiation site on the substrate 1 is shifted continuously as shown in Fig. 2(C) in such a way that the region irradiated by each pulse is superimposed on 80-98% of the preceding pulse. The scanning speed is 2cm/min. The pulse frequency is 100KHz. The beam cross-section is 50 microns thick and 10cm wide. By means of this process, a superconducting band region can be formed of 10cm width, for example.

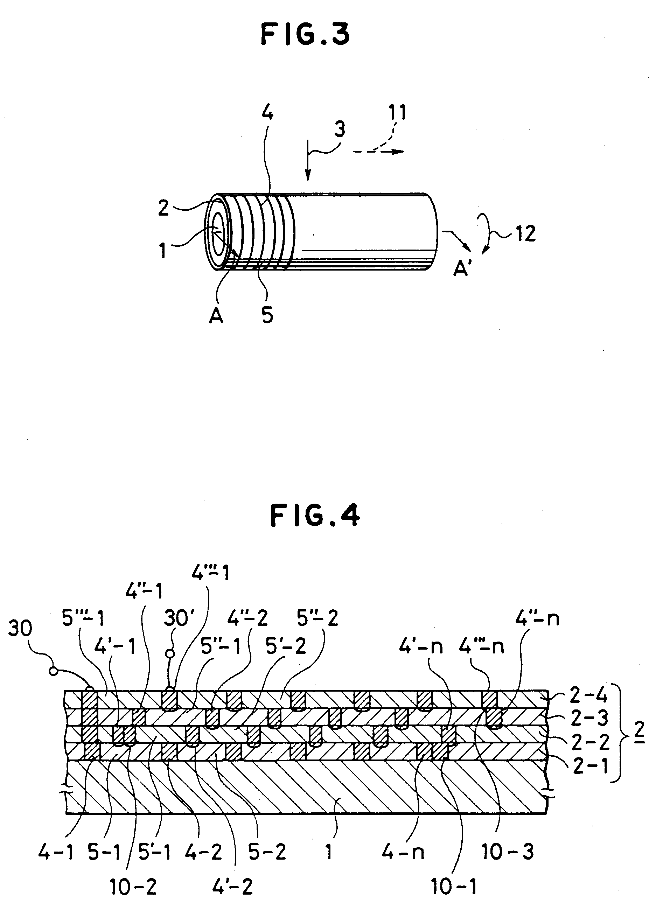

Fig. 3 shows a third embodiment of the invention. In this embodiment, substantially the same procedure is repeated as for the first embodiment except as described below. The substrate 1 is a cylinder. On the substrate surface there is deposited a ceramic film 2 by effecting sputtering while the substrate 1 is rotating in the direction indicated by the arrow 12. After completion of the film, a laser beam irradiates the substrate. The position of impingement of the laser beam is shifted in the axial direction of the cylinder 1 while the substrate 1 is rotating around its axis. By this process, a continuous helical superconductor 4 can be formed on the cylinder 1 with each part of the helix isolated from its adjacent parts by the intervening non-superconducting ceramic film 5 which has not been irradiated.

By repeating the above process described with reference to Fig. 3, a multi-layered circuit of superconducting conductors can be constructed as is illustrated in Fig. 4 which represents a fourth embodiment of the invention. As shown in Fig. 4, a first layer 2-1 is first formed with a first superconducting helix 4-1, 4-2, ...4-n in the same manner as described above with reference to Fig. 3. Then, on top of the first layer 2-1 there is deposited a second ceramic layer 2-2, and this is followed by forming a second superconducting helix 4′-1, 4′-2, ...4′-n as above described. The end 4′-n of the second helix may be connected with the end 4-n of the first helix by means of a superconductor portion 10-1 making electrical contact with the last winding of the first helix 2-1. Since the irradiation of the second layer 2-2 also causes the upper surface of the first layer 2-1 just below the irradiated portion of the second layer to be heated and melted, therefore the second helix is formed so as not to interfere with the first helix 2-1. The forming process of the second superconducting helix 2-2 is then repeated to form third and fourth ceramic layers 2-3 and 2-4 with respective third and fourth superconducting helices which, together with the first and second helices, constitute a continuous superconductor in the form of a multilayer coil. One end portion 4‴-1 of the fourth helix is connected to a wire 30′ to constitute one terminal of the coil, and the other terminal of the coil is defined by a wire 30 connected to the start end 4-1 of the first helix by way of superconducting regions of the second, third and fourth ceramic layers 2-2, 2-3 and 2-4 which are superimposed upon the end 4-1 of the first helix. If a coil having a larger number of turns is required, further ceramic layers provided with superconducting helices may be added so as to form, for example, a device comprising several tens of ceramic layers.

Although the superconducting helices are shown connected in series in Fig.4, the helices can if desired be formed without interconnections therebetween, and the superconducting patterns on the ceramic layers can be designed to produce an individual pair of terminals for each helix so that connections among the helices can be arbitrarily arranged as desired.

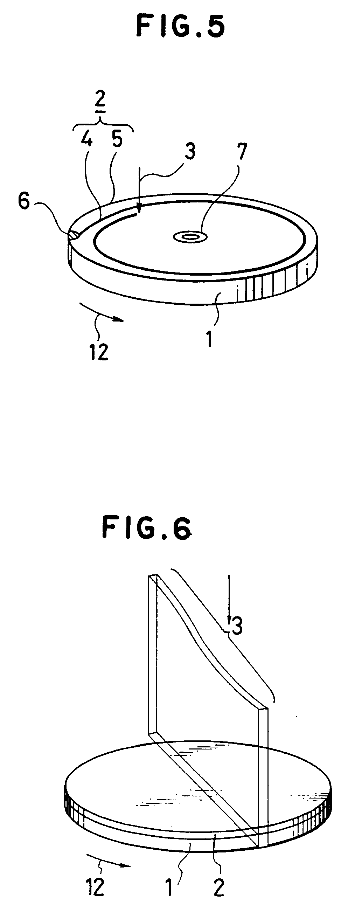

In Fig. 5 there is illustrated a fifth embodiment of the present invention. In this embodiment, the substrate 1 is an insulating disc which is provided with a terminal 6 at its periphery and a terminal 7 at its centre. The disc 1 is provided with a sputtered ceramic layer which is then irradiated with a laser beam in the same manner as described above for the first embodiment. During irradiation 3, the disc 1 is turned about its centre while the distance of the point of impingement of the laser beam from the centre is decreased so as to form a superconducting spiral 4 connecting the terminals 6 and 7 on the disc 1. According to experimental results that have been obtained Tc was measured to be 27°K. A multi-layered structure based upon the Fig. 5 embodiment can be constructed in a manner similar to that of the preceding embodiment, the arrangement comprising discs formed with spirals of opposed senses superposed in turn.

Fig. 6 is a perspective view showing a sixth embodiment of the present invention. In the figure, a linear laser beam 3 is shown radiated onto a disc 1 on which a ceramic film 2 is deposited having the composition of a superconducting ceramic as explained in the foregoing embodiments. During irradiation with the laser beam, the disc 1 is turned around its axis so that the ceramic film 2 is irradiated repeatedly with the laser beam and undergoes annealing and recrystallization.

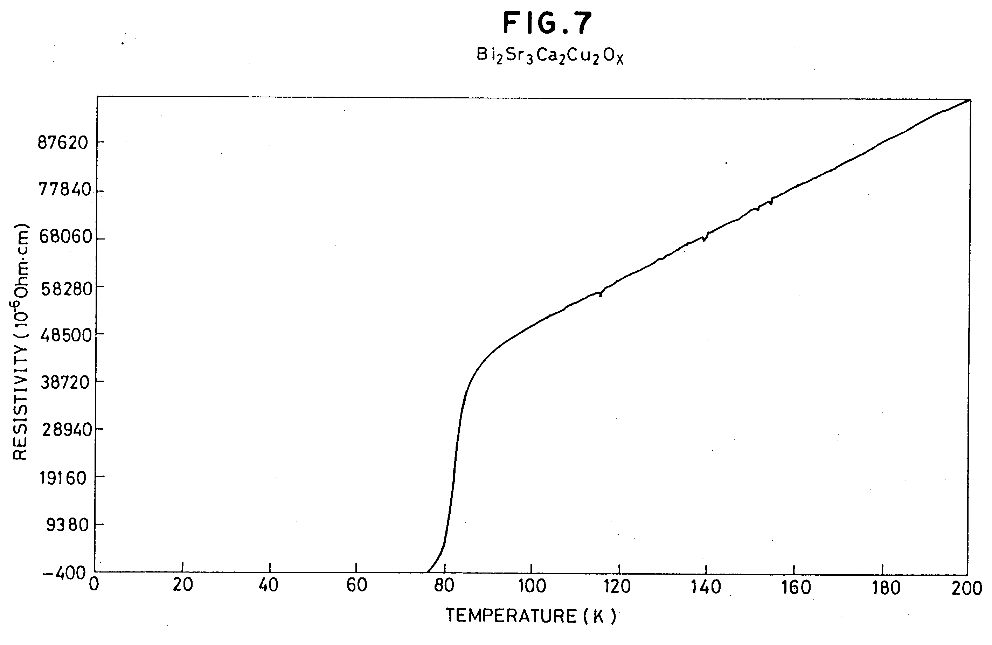

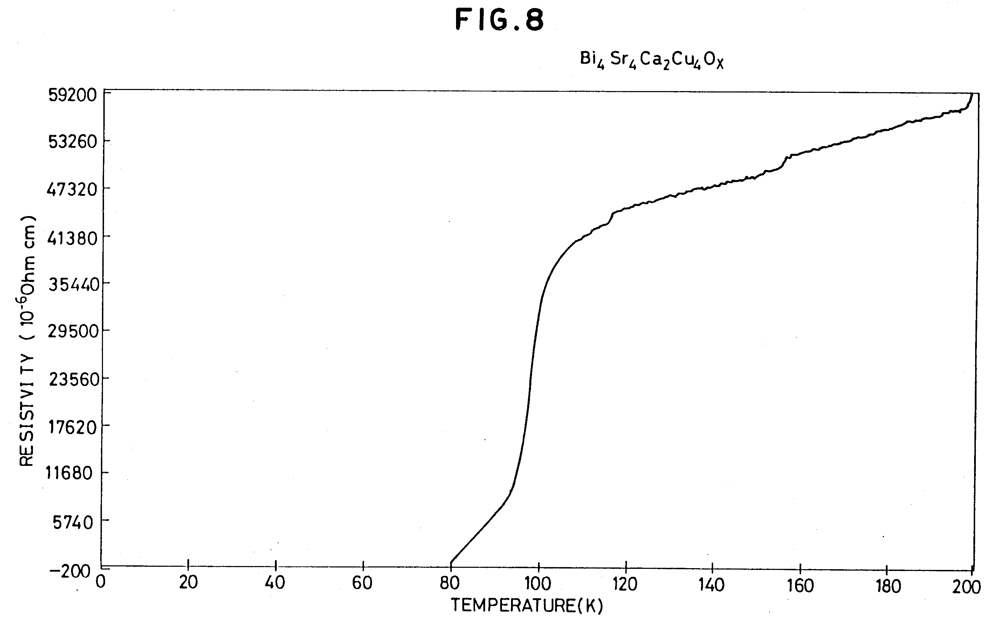

Superconducting ceramics in accordance with the present invention also may be prepared in accordance with the stoichiometric formulae (A₁₋ₓBₓ)_{y}Cu_{z}0_{w}, where A is one or more elements of Group IIIa of the Japanese Periodic Table, e.g the rare earth elements, B is one or more elements of Group IIa of the Japanese Periodic Table, e.g. the alkaline earth metals including beryllium and magnesium, and x=0-1; y=2.0-4.0, preferably 2.5-3.5; z=1.0-4.0, preferably 1.5-3.5; and w=4.0-10.0, preferably 6.0-8.0. Also, superconducting ceramics in accordance with the present invention may be prepared in accordance with the stoichiometric formulae (A₁₋ₓBₓ)_{y}Cu_{z}0_{w}, where A is one or more elements of Group Vb of the Japanese Periodic Table such as Bi, Sb and As, B is one or more elements of Group IIa of the Japanese Periodic Table, e.g. the alkaline earth metals including beryllium and magnesium, and x=0.3-1; y=2.0-4.0, preferably 2.5-3.5; z=1.0-4.0, preferably 1.5-3.5; and w=4.0-10.0, preferably 6.0-8.0. Examples of this general formula are BiSrCaCu₂Oₓ and Bi₄Sr₃Ca₃Cu₄Oₓ. Tc onset and Tco were measured for samples consistent with the formula Bi₄Sr_{y}Ca₃Cu₄Oₓ (y is around 1.5) and were found to be 40-60°K, which is not particularly high. Relatively high critical temperatures were obtained with samples conforming to the stoichiometric formulae Bi₄ Sr₄Ca₂Cu₄Oₓ and Bi₂Sr₃Ca₂Cu₂Oₓ. Figs. 7 and 8 are graphical diagrams showing the relationship between the resistivity and the temperature for both samples. The number x designating the oxygen proportion is 6-10, e.g around 8.1.

While the above description has been made with reference to several specific embodiments, it is to be understood that the present invention is not limited to the particular examples described.

## Claims

1. A method of manufacturing a high T_{c} oxide ceramic superconducting component which comprises a plurality of superconducting regions (4) separated by intervening non-superconducting regions (5), characterised by the steps of:
providing a layer (2) of oxide ceramic non-superconducting material, having a chemical composition similar to, and convertible on recrystallisation into, that of a high T_{c} superconducting oxide ceramic, on a surface (1);
irradiating with a laser beam (3) portions of said layer (2), corresponding to said superconducting regions, in an oxidising atmosphere so as to cause melting; and
permitting the irradiated portions (2) to recrystallise in a high T_{c} superconducting configuration, so as to provide said superconducting regions (4), isolated and protected by said intervening non-superconducting regions (5).

2. The method of claim 1 wherein said non-superconducting layer (2) is deposited on said surface (1) by sputtering.

3. The method of any preceding claim wherein said laser beam (3) is applied to the said layer (2) in a sequence of pulses.

4. The method of claim 3 wherein said laser beam pulses are radiated to a portion (4) of said layer (2) so as to trace a prescribed line thereon.

5. The method of any preceding claim wherein said laser beam (3) is emitted from an excimer laser.

6. The method of any preceding claim wherein the conducting portions comprise turns (4-1, 4-2...) of a superconducting coil.

7. The method of claim 6 wherein said surface (1) is constituted by the periphery of a cylinder and said laser beam (3) is radiated onto a prescribed helix on said layer (2) formed on said periphery so as to form a superconducting coil (4).

8. The method of claim 7 wherein said cylinder (1) is rotated (12) about its axis relative to said laser beam (3) during said irradiating step and the location of the impingement of said laser beam (3) on the said layer (2) is shifted in the axial direction whereby the beam (3) traces a helical path on said layer (2).

9. The method of claim 6 wherein said surface (1) is the circular surface of a disc.

10. The method of claim 9 wherein said disc (1) is rotated (12) relative to said laser beam (3) during said irradiating step and the location of the impingement of said laser beam (3) on the said layer (2) is shifted in the radial direction whereby the light traces a spiral path on the said layer (2).

11. The method of any preceding claim wherein one or more further layers (2-2...) of non-superconducting material are serially applied and irradiated whereby to form a multi-layered structure.

12. The method of claim 11 wherein the irradiated portions (4-1, 4-2...; 4′-1, 4′-2...) of the layers (2-1, 2-2) of said multi-layered structure are formed to define coils which are connected in series to form a multi-layered coil.

13. The method of any preceding claim wherein said irradiating step is carried out with said surface (1) heated to an elevated temperature of for example 300-800°C.

14. The method of claim 13 wherein said surface (1) is heated by a halogen lamp.

15. The method of any preceding claim wherein said surface (1) is made of YSZ, yttria or zirconia.

16. The method of any preceding claim, wherein the difference between the thermal expansion coefficients of the surface (1) and of the layer (2) is not greater than 50%.

17. The method of any preceding claim, wherein said superconducting regions (4) form a pattern in said layer (2).

## Patentansprüche

1. Verfahren zur Herstellung eines Bauteil aus einer supraleitenden Oxidkeramik mit hohem T_{c}, die eine Vielzahl von durch dazwischenliegende nicht-supraleitende Bereiche (5) getrennten supraleitenden Bereichen (4) enthält, gekennzeichnet durch folgende Schritte:
Aufbringen einer Schicht (2) aus nicht-supraleitendem oxidkeramischen Material mit einer chemischen Zusammensetzung ähnlich einem supraleitenden oxidkeramischen Material mit hohem T_{c}, die in dieses Material umkristallisiert werden kann, auf einen Träger (1),
Bestrahlen von Teilen der Schicht (2), die den supraleitenden Bereichen entsprechen, mit einem Laserstrahl (3) in einer oxidierenden Atmosphäre, um sie zum Schmelzen zu bringen, und
Umkristallisieren der bestrahlten Teile (2) in einer supraleitenden Konfiguration mit hohem T_{c}, um somit die supraleitenden Bereiche (4) vorzusehen, die durch die dazwischenliegenden nicht-supraleitenden Bereiche (5) getrennt und geschützt sind.

2. Verfahren nach Anspruch 1, wobei die nicht-supraleitende Schicht (2) durch Sputtern auf den Träger (1) aufgebracht wird.

3. Verfahren nach einem der vorhergehenden Ansprüche, wobei die Schicht (2) vom Laserstrahl (3) in Form einer Impulsfolge beaufschlagt wird.

4. Verfahren nach Anspruch 3, wobei die Laserstrahlimpulse einen Bereich (4) der Schicht (2) längs einer vorgegebene Linie beaufschlagen.

5. Verfahren nach einem der vorhergehenden Ansprüche, wobei der Laserstrahl (3) von einem Excimerlaser emittiert wird.

6. Verfahren nach einem der vorhergehenden Ansprüche, wobei die leitenden Bereiche Windungen (4-1, 4-2, ...) einer supraleitenden Spule umfassen.

7. Verfahren nach Anspruch 6, wobei die Fläche (1) durch den Umfang eines Zylinders gebildet wird und der Laserstrahl (3) eine vorgeschriebene Schraubenlinie auf der auf dem Umfang aufgebrachten Schicht (2) so bestrahlt, daß eine supraleitende Spule (4) entsteht.

8. Verfahren nach Anspruch 7, wobei der Zylinder (1) während der Bestrahlung um seine Achse relativ zum Laserstrahl (3) gedreht wird (12) und die Auftreffstelle des Laserstrahls (3) auf der Schicht (2) axial verschoben wird, wodurch der Strahl (3) einen schraubenlinienförmigen Pfad auf der Schicht (2) beschreibt.

9. Verfahren nach Anspruch 6, wobei die Fläche (1) die kreisförmige Oberfläche einer Scheibe ist.

10. Verfahren nach Anspruch 9, wobei die Scheibe (1) während der Bestrahlung relativ zum Laserstrahl gedreht und die Auftreffstelle des Laserstrahls auf der Schicht (2) radial verschoben wird, wodurch der Strahl (3) einen schraubenlinienförmigen Pfad auf der Schicht (2) beschreibt.

11. Verfahren nach einem der vorhergehenden Ansprüche, wobei eine oder mehrere Schichten (2-2, ...) aus nicht-supraleitendem Material nacheinander aufgebracht und bestrahlt werden, wodurch ein mehrschichtiger Aufbau entsteht.

12. Verfahren nach Anspruch 11, wobei die bestrahlten Bereiche (4-1, 4-2, ...; 4′-1, 4′-2, ...) der Schichten (2-1, 2-2) des mehrschichtigen Aufbaus so gebildet werden, daß sie Windungen beschreiben, die zu einer mehrschichtigen Spule in Serie geschaltet werden.

13. Verfahren nach einem der vorhergehenden Ansprüche, wobei die Bestrahlung unter Erwärmung der Fläche (1) auf eine Temperatur von beispielsweise 300 - 800°C durchgeführt wird.

14. Verfahren nach Anspruch 13, wobei die Fläche (1) durch eine Halogenlampe erwärmt wird.

15. Verfahren nach einem der vorhergehenden Ansprüche, wobei die Fläche (1) aus YSZ, Yttriumoxid oder Zirconiumdioxid besteht.

16. Verfahren nach einem der vorhergehenden Ansprüche, wobei der Unterschied zwischen den Wärmeausdehnungskoeffizienten der Fläche (1) und der Schicht (2) nicht mehr als 50% beträgt.

17. Verfahren nach einem der vorhergehenden Ansprüche, wobei die supraleitenden Bereiche (4) ein Muster in der Schicht (2) bilden.

## Revendications

1. Procédé de fabrication d'un composant supraconducteur en céramique d'oxyde à T_{c} élevée, qui comporte plusieurs régions supraconductrices (4) séparées par des régions (5) non supraconductrices intermédiaires, caractérisé par les étapes consistant à:
former sur une surface (1) une couche (2) de matériau non supraconducteur en céramique d'oxyde, présentant une composition chimique similaire à, et pouvant être transformée par recristallisation en, celle d'une céramique d'oxyde supraconductrice à T_{c} élevée;
irradier par un faisceau laser (3) des parties de ladite couche (2) qui correspondent auxdites régions supraconductrices, dans une atmosphère oxydante, de manière à provoquer une fusion; et
permettre aux parties irradiées (2) de recristalliser dans une configuration supraconductrice à T_{c} élevée, de manière à fournir lesdites régions supraconductrices (4), isolées et protégées par lesdites régions non-supraconductrices (5) intermédiaires.

2. Procédé selon la revendication 1, dans lequel ladite couche (2) non-supraconductrice est déposée sur ladite surface (1) par pulvérisation cathodique.

3. Procédé selon l'une quelconque des revendications précédentes, dans lequel ledit faisceau laser (3) est appliqué sur ladite couche (2) sous la forme d'une succession de pulsations.

4. Procédé selon la revendication 3, dans lequel lesdites impulsions du faisceau laser sont envoyées sur une partie (4) de ladite couche (2) de manière à tracer sur elle une ligne prescrite.

5. Procédé selon l'une quelconque des revendications précédentes, dans lequel ledit faisceau laser (3) est émis par un laser excimer.

6. Procédé selon l'une quelconque des revendications précédentes, dans lequel les parties conductrices comportent des enroulements (4-1, 4-2, ...) d'un bobinage supraconducteur.

7. Procédé selon la revendication 6, dans lequel ladite surface (1) est constituée par la périphérie d'un cylindre, et ledit faisceau laser (3) est envoyé sur une hélice prescrite sur ladite couche (2), formée sur ladite périphérie, de manière à former un bobinage supraconducteur (4).

8. Procédé selon la revendication 7, dans lequel ledit cylindre (1) est mis en rotation (12) autour de son axe par rapport audit faisceau laser (3) au cours de ladite étape d'irradiation, et l'emplacement de l'impact dudit faisceau laser (3) sur ladite couche (2) est décalé dans la direction axiale, grâce à quoi le faisceau (3) trace une trajectoire hélicoïdale sur ladite couche (2).

9. Procédé selon la revendication 6, dans lequel ladite surface (1) est la surface circulaire d'un disque.

10. Procédé selon la revendication 9, dans lequel ledit disque (1) est mis en rotation (12) par rapport audit faisceau laser (3) au cours de ladite étape d'irradiation, et l'emplacement de l'impact dudit faisceau laser (3) sur ladite couche (2) est décalé dans la direction radiale, grâce à quoi la lumière trace une trajectoire en spirale sur ladite couche (2).

11. Procédé selon l'une quelconque des revendications précédentes, dans lequel une ou plusieurs autres couches (2-2, ...) de matériau non-supraconducteur sont appliquées et irradiées successivement, de manière à former une structure multi-couches.

12. Procédé selon la revendication 11, dans lequel les parties irradiées (4-1, 4-2, ...; 4′-1, 4′-2, ...) des couches (2-1, 2-2) de ladite structure multi-couches sont configurées de manière à définir des bobinages qui sont reliés en série pour former un bobinage multi-couches.

13. Procédé selon l'une quelconque des revendications précédentes, dans lequel ladite étape d'irradiation est conduite avec ladite surface (1) chauffée à une température élevée, par exemple de 300-800°C.

14. Procédé selon la revendication 13, dans lequel ladite surface (1) est chauffée par une lampe à halogène.

15. Procédé selon l'une quelconque des revendications précédentes, dans lequel ladite surface (1) est réalisée en YSZ, en yttria ou en zircone.

16. Procédé selon l'une quelconque des revendications précédentes, dans lequel la différence entre le coefficient de dilatation thermique de la surface (1) et celui de la couche (2) n'est pas supérieure à 50%.

17. Procédé selon l'une quelconque des revendications précédentes, dans lequel lesdites régions supraconductrices (4) forment un motif dans ladite couche (2).
